# EUROPEAN PATENT SPECIFICATION

(11) **EP 0 483 108 B1**
(45) Date of publication and mention of the grant of the patent: **24.06.1998**
(21) Application number: 92100518.7
(22) Date of filing: 03.10.1986
(51) Int. Cl.: H05K 7/20, H01L 23/46, H01L 23/473

(54) **Cooling modules for electronic circuit components**
Kühlmodule für Vorrichtungen mit elektronischem Schaltkreis
Modules de refroidissement pour dispositifs de circuit électronique

(30) Priority: 04.10.1985 JP 221209/85; 19.11.1985 JP 259284/85
(43) Date of publication of application: 29.04.1992
(62) Divisional of application: 86307669.1
(73) Proprietor: FUJITSU LIMITED, Kawasaki-shi, Kanagawa 211 (JP)
(72) Inventor: Yamamoto, Haruhiko, Yokohama-shi, Kanagawa 222 (JP); Suzuki, Masahiro, Inagi-shi, Tokyo 206 (JP); Udagawa, Yoshiaki, Tokyo 155 (JP); Ono, Izumi, Hachioji-shi, Tokyo 192 (JP)
(74) Representative: Fane, Christopher Robin King

(56) References cited:
- EP-A- 0 144 579
- EP-A- 0 151 068
- IBM TECHNICAL DISCLOSURE BULLETIN, vol.23, no.11, April 1981, NY,US pages 4954 - 4955

## Description

The present invention relates to cooling modules for electronic circuit devices.

A printed circuit board holding electronic circuit components, such as semiconductors, large scale integrated circuits (LSI's), or integrated circuit (IC's), may be cooled by a series of cooling modules which are operable to remove the heat dissipated from the components.

Fujitsu Limited's prior European patent application published under the number EP-A-0151068 disclosed a cooling module, in combination with an electronic circuit component mounted on a printed circuit board, including a heat transfer plate, for conducting heat from the electronic circuit component to a coolant in the module, resilient biasing means connected to the heat transfer plate and serving to urge that plate towards the circuit component, and nozzle means arranged for emitting a stream of such coolant towards an opposing main face of the heat transfer plate, which main face is provided with a plurality of ridges to facilitate transfer of such heat to the coolant.

It is desirable to improve the efficiency of heat transfer of such a cooling module.

According to the present invention there is provided a cooling module, in combination with an electronic circuit component mounted on a printed circuit board, including a heat transfer plate, for conducting heat from the said electronic circuit component to a coolant in the module, resilient biasing means connected to the heat transfer plate and serving to urge that plate towards the said circuit component, and nozzle means arranged for emitting a stream of such coolant towards an opposing main face of the heat transfer plate, which main face is provided with a plurality of ridges to facilitate transfer of such heat to the coolant, **characterised in that** the said ridges are substantially annular in form and are arranged so as to be substantially coaxial with the said stream of coolant emitted from the said nozzle means, thereby to encourage turbulence in such coolant adjacent to the said main face.

The nozzle means may be such that the stream emitted thereby is circular in cross-section, having a diameter D on emerging from the nozzle means, and the substantially annular ridges may be arranged so as to have a pitch P between adjacent ridges, and respective heights e and widths w, such that the following relationships are obeyed:
e/D=1/20 ∼ 1/3; P/e=3 ∼ 10; and w/e ≒ 1.

Preferably, the pitch P between adjacent ridges increases outwardly from the axis of the emitted stream of coolant, so that the pitch between the two adjacent ridges closest to that axis is smaller than that between the two adjacent ridges furthest therefrom. In one embodiment, the respective heights e of the substantially annular ridges increase outwardly from the axis of the emitted stream of coolant, so that the height of the ridge closest to that axis is less than that of the ridge furthest therefrom.

The respective ratios e/D for the substantially annular ridges may increase outwardly from the axis, so that the ratio for the ridge closest to that axis is smaller than that for the ridge furthest therefrom.

Each of the substantially annular ridges may with advantage be a discontinuous annulus. The recesses defined between adjacent ridges of the plurality in one embodiment of the invention are semicircular in cross-section.

Reference will now be made, by way of example, to the accompanying drawings, in which:
Fig. 1 is a schematic axial sectional view of a first electronic circuit device not embodying the present invention;
Fig. 2 is a schematic axial sectional view of an assembly of devices similar to Fig. 1;
Fig. 3 is a diagrammatic perspective view of the assembly shown in Fig. 2;
Fig. 4 is a schematic perspective view of part of a second electronic circuit device not embodying the present invention;
Fig. 5 is an axial sectional view of Fig. 4;
Fig. 6 shows a graph relating to the device of Fig. 4;
Fig. 7 is an axial sectional view of an electronic circuit device embodying the present invention;
Fig. 8 is an enlarged diagrammatic plan view of part of the device of Fig. 7;
Fig. 9 is an enlarged partial cross-sectional view of the part shown in Fig. 8;
Fig. 10 is a plan view, similar to Fig. 8, but showing a variant thereof;
Fig. 11 is an explanatory cross-sectional view similar to that shown in Fig. 9;
Figs. 12 and 13 are explanatory cross-sectional views corresponding to Fig. 11 but showing respective modified forms of the part concerned; and
Fig. 14 shows graphs illustrating experimental results.

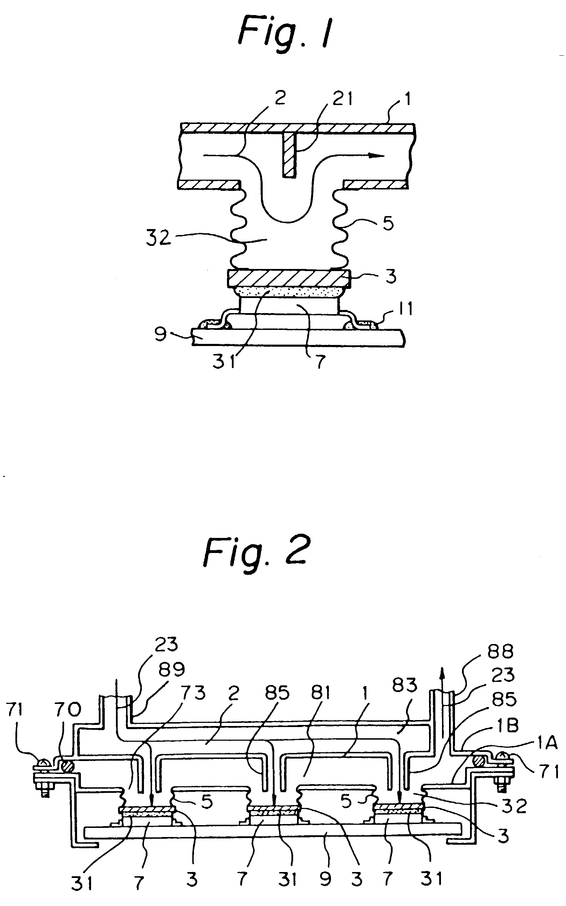

Figure 1 shows an electronic circuit device, not embodying the present invention, including a cooling module having a passage 1 for coolant flow.

The coolant can be gas but it is not limited thereto, or may be a liquid, such as water, liquid fluorocarbon, or even a liquid metal such as mercury or gallium. The passage 1 may be a part of a recirculation line having a pump and a heat radiator or heat exchanger.

A heat transfer plate 3 which is made of, for example, a heat conductive material such as copper or brass, is connected to the passage 1 by means of a bellows 5 attached to the passage 1. The heat transfer plate 3 may be made of a metal having a high solder wetting property. The bellows 5 may be made of a thin sheet of copper or stainless steel. The passage 1 has a deflector 21 extending towards the heat transfer plate 3. A coolant circulation zone 32 is defined in the bellows 5, in which zone 32 the heat transfer plate 3 is exposed to the coolant at one main face of the plate 3.

The direction of the coolant flow in the passage 1 is changed by the deflector 21, and heat is removed from the heat transfer plate 3 in the circulation zone 32.

The plate 3 is urged resiliently towards an electronic circuit component 7, such as a semiconductor IC or LSI, provided on a printed circuit board 9, by means of the bellows 5 and the hydraulic pressure of the coolant.

The component 7 is bonded to the printed circuit board 9 by, for example, solder 11.

In the device of Figure 1, an intermediate layer of solder 31 is provided between the heat transfer plate 3 and the circuit component 7. The intermediate layer 31 is secured to the bottom face of the heat transfer plate 3. Alternatively, the intermediate layer 31 can be secured to the circuit component 7 on the printed circuit board 9.

The solder 31 maintains its original sheet-like shape at a normal temperature, i.e. when the circuit device is not in operation. When the circuit device is operated, and consequently produces heat, the solder 31 is melted so that the heat transfer plate 3 and the circuit component 7 are joined by the solder 31. Thus, the plate 3 and component 7 can be connected to each other in a substantially complete face-to-face fashion, regardless of any unevenness of the contacting surfaces thereof.

Thus, cooling efficiency of the cooling module can be high, because the second solder 31 ensures a thermal connection between the heat transfer plate 3 and the circuit component 7.

Figure 2 shows an assembly of cooling modules similar in principle to that of Figure 1, in which the passage 1 comprises a lower half 1A and an upper half 1B. The lower half 1A has, for example, a generally U-shaped cross section, and has openings 73 connected to the recirculation zones 32 of the cooling modules. The upper half 1B can be fitted onto the lower half 1A to define an outlet passage 81.

The upper half 1B, therefore, acts as a cover of the passageway for the coolant 2. The upper half 1B has an upper inlet passage 83 which corresponds to the passage 1 in Fig. 1. The passage 83 is connected to the outlet passage 81 by nozzles 85, so that the coolant 2 fed through a recirculation line is fed or ejected towards the respective opposing main faces of the heat transfer plates 3 of the cooling modules through the nozzles 85, and is returned to the recirculation line through the outlet passage 81 and an outlet pipe 88 provided on the upper half 1B of the passage 1. The coolant 2 can be introduced into the inlet passage 83 from an inlet pipe 89 provided on the upper half 1B.

The upper half 1B can be detachably connected to the lower half by, for example, bolts 71.

The numeral 70 designates a seal, such as a ring packing or a gasket, which is located between the upper and lower halves 1A and 1B to seal the connection therebetween.

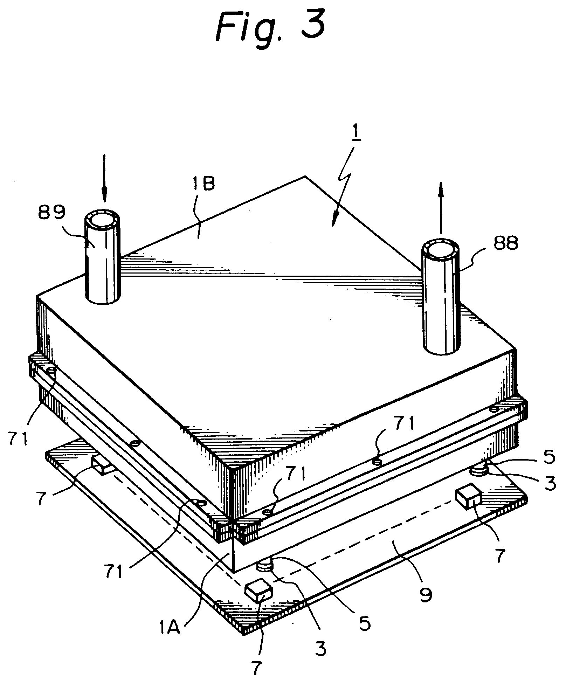

Figure 3 shows one example of a perspective appearance of a cooling unit having an assembly of cooling modules such as are shown in Fig. 2. In Fig. 3, the inlet pipe 89 and the outlet pipe 88 are in different positions from those shown in Fig. 2. The cover 1B can be detached from the lower half 1A by removing the bolts 71.

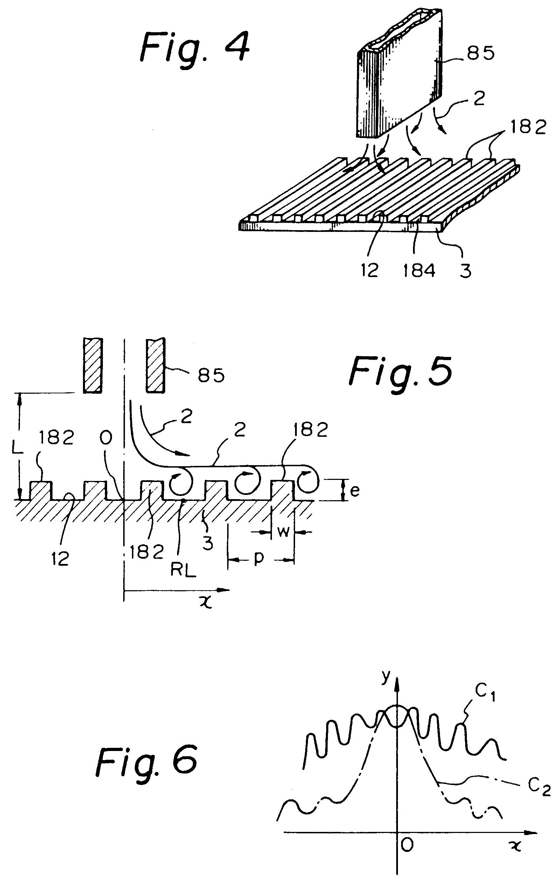

In order to increase the heat conductivity of the heat transfer plate 3, a means can be provided for producing turbulence in the flow of the coolant 2, as shown in Figs. 4 to 6.

In a second electronic circuit device not embodying the present invention, which device is illustrated in Figs. 4 and 5, the plate 3 is provided with a plurality of parallel ridges 182, which serve to increase the area of the main heat transmission face of the plate 3 in contact with the coolant 2. The nozzle 85 has a rectangular cross section and the ridges 182 extend parallel to the length of the rectangle formed by the nozzle 85. When the coolant 2 is ejected from the nozzle 85 onto the plate 3, the coolant flowing on the main face 12 is disturbed by the ridges 182, so that turbulence of the coolant 2 occurs on the plate 3.

This turbulence causes a disturbance in the flow of the coolant 2 on contact with the main heat transmission face 12 of the plate 3, resulting in the production of vortices in the flow of the coolant 2, as can be seen in Fig. 5. The vortices locally increase the heat transfer. The flow of the coolant 2, disturbed from the laminar flow and forming the vortices, impinges additionally on the face 12 at a point RL. The heat transfer can thus be increased locally, particularly in the vicinity of the point RL.

With reference to Fig. 6, which shows a relationship between the heat transferred y and the distance x from a point 0 directly below the nozzle opening of the nozzle 85 and on the face 12 of the plate 3. The solid line C1 represents the device of Figs. 4 and 5 in which the ridges 182 are provided on the plate 3, and the dash-dot line C2 represents a device in which no ridges are provided on the plate 3 (flat face plate). As can be seen from Fig. 6, the ridges 182 increase the heat transfer even at locations far from the centre point 0. In contrast, if there are no ridges on the plate the heat transfer is high only at or near to the centre point 0. Thus the ridges 182 provide a more uniform distribution of the heat transfer over the entire surface of the plate 3 but the heat transfer still decreases slightly as the distance x from the centre 0 of the face 12 increases. The curve C1 varies in accordance with the distance L between the lower end of the nozzle 85 and the heat transmission face 12 of the plate 3, the width w of a ridge 182, the height e of the ridges 182, and the pitch P of the ridges 182.

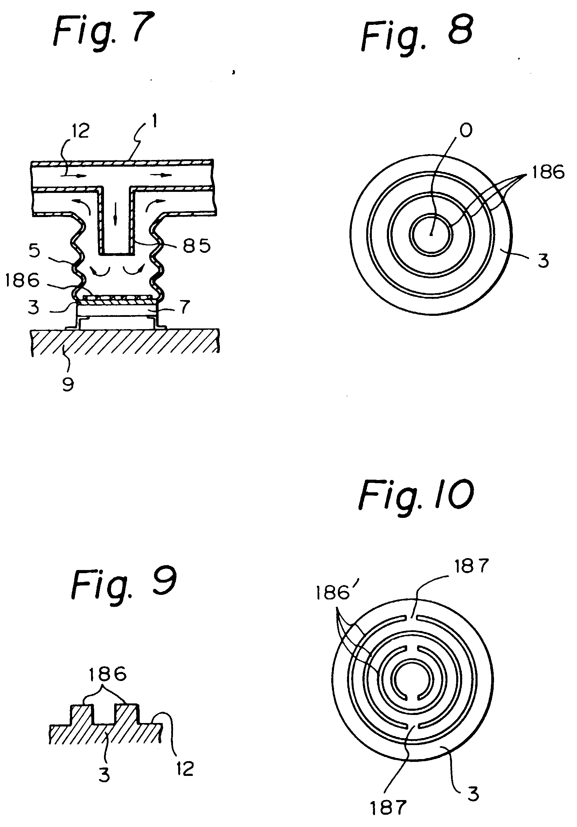

Figures 7 to 9 show a cooling module, embodying the present invention, in which the plate 3 has a plurality of annular ridges 186 coaxial to each other on the heat transmission face 12.

The ridges 186 are rectangular in cross section. The plate 3 is circular in plan view. The nozzle 85, which has a circular cross section, is located directly above the centre of the plate 3, so as to be coaxial with the annular ridges 186. It is found that this form of construction can give a more uniform distribution of a higher heat transfer, than can be expected from an arrangement as shown in Fig. 4.

It should be noted that each ridge 186 need not always be a complete circle but can be discontinuous with a gap as shown in Fig. 10, or with a plurality of gaps.

In Fig. 10, each of the annular ridges 186 in Fig. 9 is replaced by a separate discontinuous annular ridge 186'. Thus, each annular ridge 186' has a small gap 187 to define a discontinuous annular ridge.

Preferably, the gaps 187 of respective ridges are displaced from one another in the circumferential direction.

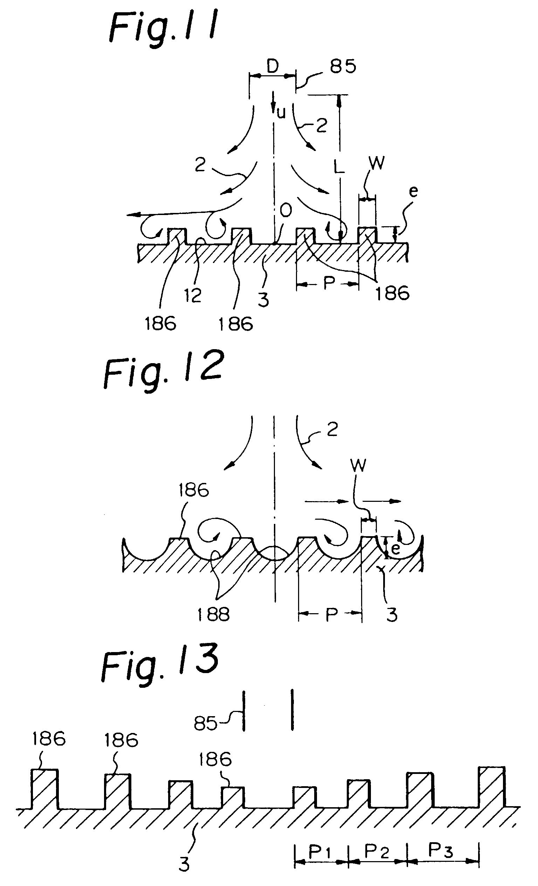

In Fig. 11, the stream of coolant 2 emitted from the nozzle 85 impinges on a central region of the opposing main face 12 of the plate 3, within the innermost annular ridge 186 (or 186'), and spreads outwardly over the surrounding ridges 186 (or 186'). The same phenomena take place at each of the ridges 186 (or 186') and vortices occur as shown in Fig. 11.

It is also possible and preferable to provide round recesses 188, of semicircular cross section, between the annular ridges 186 (or 186'), as shown in Fig. 12. Such round recesses 188 assist the production and maintenance of the vortices.

Figure 13 shows an alternative arrangement of the annular ridges 186 or 186', in which the ridges have different pitches and different heights. The pitches vary so that the pitch P₁ between the innermost ridge and its adjacent ridge is smallest and the pitch increases towards the outer ridges. Thus, in Fig. 13, P₃ > P₂ > P₁. The heights vary so that the height of the innermost ridge is smallest and the height increases toward the outer ridges.

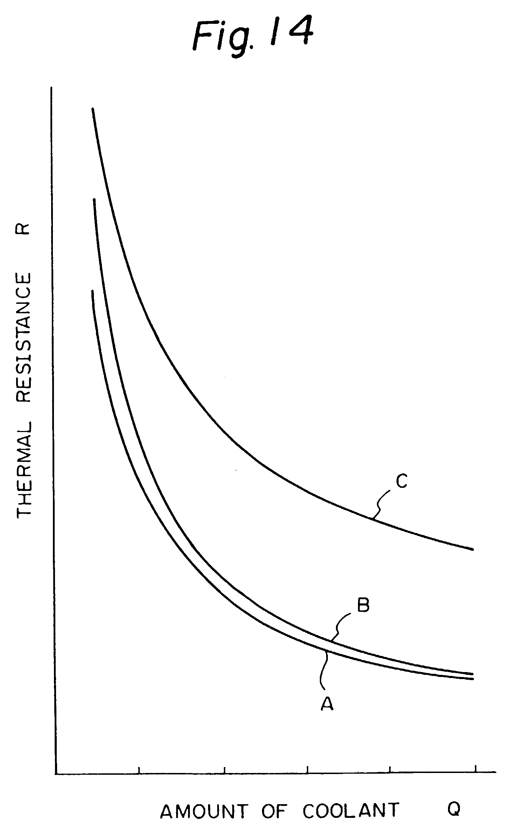

Figure 14 shows graphs illustrating experimental results of three heat transfer plates. The first heat transfer plate A is that shown in Fig. 12, which has the round recesses 188 between the annular ridges 186; the second heat transfer plate B is that shown in Fig. 11, which has annular ridges 186 and flat surface portions between the ridges; and the third heat transfer plate does not have ridges, being the same as that used in the experiment shown in Fig. 6 and represented by the curve C2.

In the experiments, the internal diameter D of the nozzle 85, the width w of the ridge 186, the height e of a ridge 186, and the pitch P of the ridges 186 had the following relationship:
w/D = 0.1 ; e/w = 1 ; P/e = 5 (for heat transfer plate A).

The heat transfer plate B had the same width w, pitch P, and diameter D as the heat transfer plate A. In Fig. 14, the ordinate axis designated by R represents the effective thermal resistance between the coolant 2 and the heat transmission face 12 of the plate 3, and the abscissa axis designated by Q represents the rate of flow of the coolant 2. It will be understood that, when the flow of coolant is relatively large, the effective thermal resistance R can be decreased by about one half by the provision of the ridges 186.

It will be also understood that the round recesses 188 contribute to a decrease of the effective thermal resistance R.

The experimental results shown in Fig. 4 were obtained with an arrangement in which L/D ≦ 6 ∼ 8.

The optimum values of w, e, p depend on the values of L and D. Preferably e/D = 1/20 ∼ 1/3, P/e = 3 ∼ 10, and w/e ≒ 1, for the embodiment shown in Fig. 11, and P/D = 0.2 ∼ 2, w/D = 1/20 ∼ 1/3, for the embodiment shown in Fig. 12, respectively; where L/D ≦ 6 ∼ 8, the Reynolds number N_{Re} = uD/γ = 1000 ∼ several tens of thousands (wherein, u = the velocity of the coolant emitted from the nozzle 85, and γ = the coefficient of kinematic viscosity).

It is possible to design an arrangement having the relationship between P, D, e in such a way that e/D and/or P/D increases from the innermost ridge towards the outer ridges.

The cooling apparatus can be used upside down, so that the coolant is ejected upward from the nozzles 85 towards the heat transfer plates 3 located above the nozzles 85.

## Claims

1. A cooling module, in combination with an electronic circuit component (7) mounted on a printed circuit board (9), including a heat transfer plate (3), for conducting heat from the said electronic circuit component (7) to a coolant (2) in the module, resilient biasing means (5) connected to the heat transfer plate (3) and serving to urge that plate (3) towards the said circuit component (7), and nozzle means (85) arranged for emitting a stream of such coolant (2) towards an opposing main face of the heat transfer plate (3), which main face is provided with a plurality of ridges (186, 186') to facilitate transfer of such heat to the coolant (2), **characterised in that** the said ridges (186, 186') are substantially annular in form and are arranged so as to be substantially coaxial with the said stream of coolant (2) emitted from the said nozzle means (85), thereby to encourage turbulence in such coolant adjacent to the said main face.

2. A cooling module as claimed in claim 1, wherein the said nozzle means (85) are such that the said stream emitted thereby is circular in cross-section, having a diameter D on emerging from the nozzle means (85), and the said substantially annular ridges (186, 186') are arranged so as to have a pitch P between adjacent ridges, and respective heights e and widths w, such that e/D is in the range from 1/20 to 1/3, P/e is in the range from 3 to 10, and w/e is substantially equal to 1.

3. A cooling module as claimed in claim 2, wherein the said pitch P between adjacent ridges (186, 186') increases outwardly from the axis (O) of the emitted stream of coolant (2), so that the pitch between the two adjacent ridges closest to that axis is smaller than that between the two adjacent ridges furthest therefrom.

4. A cooling module as claimed in claim 3, wherein the respective heights e of said substantially annular ridges (186, 186') increase outwardly from the axis (O) of the emitted stream of coolant (2), so that the height of the ridge (186, 186') closest to that axis is less than that of the ridge (186, 186') furthest therefrom.

5. A cooling module as claimed in claim 4, wherein the respective ratios e/D for said substantially annular ridges (186, 186') increase outwardly from the said axis (O), so that the ratio for the ridge closest to that axis is smaller than that for the ridge furthest therefrom.

6. A cooling module as claimed in any one of claims 1 to 5, wherein each of said substantially annular ridges (186, 186') is a discontinuous annulus (186').

7. A cooling module as claimed in any one of claims 1 to 6, wherein the recesses (188) defined between adjacent ridges (186) of the said plurality are semicircular in cross-section.

## Patentansprüche

1. Kühlmodul in Kombination mit einem elektronischen Schaltungsbauelement (7), das auf eine gedruckte Schaltungsplatte (9) montiert ist, das eine Wärmeübertragungsplatte (3) enthält, zum Leiten von Wärme von dem elektronischen Schaltungsbauelement (7) zu einem Kühlmittel (2) in dem Modul, ein elastisches Vorspannmittel (5), das mit der Wärmeübertragungsplatte (3) verbunden ist und dazu dient, jene Platte (3) hin zu dem Schaltungsbauelement (7) zu drängen, und ein Düsenmittel (85), das zum Emittieren eines Stroms eines solchen Kühlmittels (2) hin zu einer gegenüberliegenden Hauptfläche der Wärmeübertragungsplatte (3) angeordnet ist, welche Hauptfläche mit einer Vielzahl von Rippen (186, 186') versehen ist, um die Übertragung solch einer Wärme zu dem Kühlmittel (2) zu erleichtern, dadurch gekennzeichnet, daß die Rippen (186, 186') im wesentlichen ringförmig sind und angeordnet sind, um mit dem Strom des Kühlmittels (2), der von dem Düsenmittel (85) emittiert wird, im wesentlichen koaxial zu sein, um dadurch die Turbulenz in solch einem Kühlmittel angrenzend an die Hauptfläche zu fördern.

2. Kühlmodul nach Anspruch 1, bei dem das Düsenmittel (85) so ist, daß der Strom, der durch dieses emittiert wird, einen runden Querschnitt hat, wobei er beim Austreten aus dem Düsenmittel (85) einen Durchmesser D hat, und die im wesentlichen ringförmigen Rippen (186, 186') so angeordnet sind, um eine Teilung P zwischen benachbarten Rippen und jeweilige Höhen e und Breiten w zu haben, so daß e/D im Bereich von 1/20 bis 1/3 liegt, P/e im Bereich von 3 bis 10 liegt und w/e im wesentlichen gleich 1 ist.

3. Kühlmodul nach Anspruch 2, bei dem die Teilung P zwischen benachbarten Rippen (186, 186') von der Achse (0) des emittierten Stroms des Kühlmittels (2) nach außen hin zunimmt, so daß die Teilung zwischen den zwei benachbarten Rippen, die jener Achse am nächsten sind, kleiner als die zwischen den zwei benachbarten Rippen ist, die am weitesten von ihr entfernt sind.

4. Kühlmodul nach Anspruch 3, bei dem die jeweiligen Höhen e der im wesentlichen ringförmigen Rippen (186, 186') von der Achse (0) des emittierten Stroms des Kühlmittels (2) nach außen hin zunehmen, so daß die Höhe von der Rippe (186, 186'), die jener Achse am nächsten ist, kleiner als die von der Rippe (186, 186') ist, die am weitesten von ihr entfernt ist.

5. Kühlmodul nach Anspruch 4, bei dem die jeweiligen Verhältnisse e/D bei den im wesentlichen ringförmigen Rippen (186, 186') von der Achse (0) nach außen hin zunehmen, so daß das Verhältnis bei der Rippe, die jener Achse am nächsten ist, kleiner als das bei der Rippe ist, die am weitesten von ihr entfernt ist.

6. Kühlmodul nach irgendeinem der Ansprüche 1 bis 5, bei dem jede der im wesentlichen ringförmigen Rippen (186, 186') ein unterbrochener Ring (186') ist.

7. Kühlmodul nach irgendeinem der Ansprüche 1 bis 6, bei dem die Vertiefungen (188), die zwischen benachbarten Rippen (186) von der genannten Vielzahl definiert sind, einen halbrunden Querschnitt haben.

## Revendications

1. Module de refroidissement, combiné à un composant (7) de circuit électronique monté sur une carte de circuit imprimé (9), comprenant une plaque de transfert de chaleur (3) destinée à conduire de la chaleur du composant (7) de circuit électronique à un fluide de refroidissement (2) placé dans le module, un dispositif élastique de rappel (5) raccordé à la plaque (3) de transfert de chaleur et utilisé pour rappeler cette plaque (3) vers le composant (7) du circuit, et un dispositif à buse (85) disposé afin qu'il émette un courant du fluide de refroidissement (2) vers une face principale opposée de la plaque (3) de transfert de chaleur, cette face principale ayant plusieurs nervures (186, 186') destinées à faciliter le transfert de chaleur au fluide de refroidissement (2), caractérisé en ce que les nervures (186, 186') ont une forme pratiquement annulaire et sont disposées afin qu'elles soient pratiquement coaxiales au courant du fluide de refroidissement (2) qui est émis par le dispositif à buse (85), si bien que la turbulence d'un fluide de refroidissement est favorisé près de la face principale.

2. Module de refroidissement selon la revendication 1, dans lequel le dispositif à buse (85) est tel que le courant qu'il émet a une section circulaire, de diamètre D lorsqu'il sort du dispositif à buse (85), et les nervures pratiquement annulaires (186, 186') sont disposées afin qu'elles aient un pas P compris entre des nervures adjacentes et des hauteurs respectives e et des largeurs respectives w telles que e/D est compris entre 1/20 et 1/3, P/e est compris entre 3 et 10 et w/e est pratiquement égal à 1.

3. Module de refroidissement selon la revendication 2, dans lequel le pas P des nervures adjacentes (186, 186') augmente vers l'extérieur depuis l'axe (O) du courant de fluide de refroidissement (2) qui est émis, si bien que le pas des nervures adjacentes les plus proches de l'axe est inférieur à celui de deux nervures adjacentes plus éloignées de l'axe.

4. Module de refroidissement selon la revendication 3, dans lequel les hauteurs respectives e des nervures pratiquement annulaires (186, 186') augmentent vers l'extérieur depuis l'axe (O) du courant de fluide de refroidissement (2) qui est émis, si bien que la hauteur de la nervure (186, 186') la plus proche de l'axe est inférieure à celle de la nervure (186, 186') la plus éloignée de l'axe.

5. Module de refroidissement selon la revendication 4, dans lequel les rapports respectifs e/D des nervures sensiblement annulaires (186, 186') augmentent vers l'extérieur depuis ledit axe (O) si bien que le rapport pour la nervure la plus proche de l'axe est plus petit que pour la nervure la plus éloignée de l'axe.

6. Module de refroidissement selon l'une quelconque des revendications 1 à 5, dans lequel chacune des nervures pratiquement annulaires (186, 186') est un anneau discontinu (186').

7. Module de refroidissement selon l'une quelconque des revendications 1 à 6, dans lequel les cavités (188) délimitées entres des nervures adjacentes (186) de l'ensemble de nervures ont une section en demi-cercle.
